# EUROPEAN PATENT SPECIFICATION

(11) **EP 0 344 702 B1**
(45) Date of publication and mention of the grant of the patent: **13.03.1996**
(21) Application number: 89109709.9
(22) Date of filing: 30.05.1989
(51) Int. Cl.: H01L 23/488, H01L 23/50, H01L 23/32

(54) **Electric circuit apparatus**
Elektrischer Schaltungsapparat
Appareil à circuit électronique

(30) Priority: 30.05.1988 JP 133136/88; 30.05.1988 JP 133137/88; 31.05.1988 JP 133391/88; 31.05.1988 JP 133392/88; 31.05.1988 JP 133393/88; 31.05.1988 JP 133394/88
(43) Date of publication of application: 06.12.1989
(73) Proprietor: CANON KABUSHIKI KAISHA, Tokyo (JP)
(72) Inventor: Kondo, Hiroshi, Yokohama-shi Kanagawa-ken (JP); Terayama, Yoshimi, Odawara-shi Kanagawa-ken (JP); Sakaki, Takashi, Tokyo (JP); Haga, Shunichi, Yokohama-shi Kanagawa-ken (JP); Yoshizawa, Tetsuo, Yokohama-shi Kanagawa-ken (JP); Ichida, Yasuteru, Machida-shi Tokyo (JP); Konishi, Masaki, Ebina-shi Kanagawa-ken (JP)
(74) Representative: Tiedtke, Harro, Dipl.-Ing.

(56) References cited:
- EP-A- 0 148 083
- EP-A- 0 245 179
- EP-A- 0 284 820
- EP-A- 0 329 133
- DE-A- 3 635 154
- US-A- 4 417 777
- US-A- 4 597 617
- IBM Technical Disclosure Bulletin, vol. 27, no. 8, January 1985, page 4855
- IBM Technical Disclosure Bulletin, vol. 27, no. 8, January 1985, page 4855

## Description

The present invention relates to an electric circuit apparatus according to the preamble of the claim.

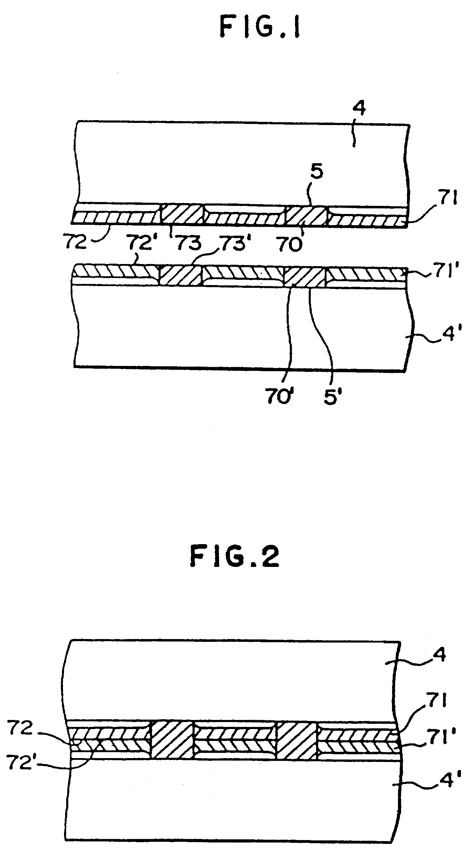

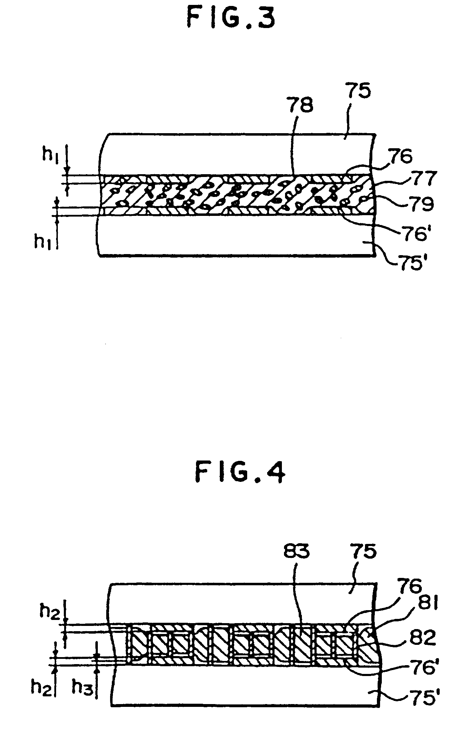

Hitherto, known techniques for electrically connecting electric circuit components are exemplified by:
(1) wire bonding method
(2) TAB (Tape Automated Bonding) method (for example, an art disclosed in Japanese Patent Laid-Open No. 59-139636)
(3) CCP (Controlled Collapse Bonding) method (for example, see Japanese Patent Publication No. 42-2096 and Japanese Patent Laid-Open No. 60-57944)
(4) An art shown in Figs. 1 and 2
(5) An art shown in Fig. 3
(6) An art shown in Fig. 4
where the art shown in Figs. 1 and 2 is characterized in that:
an insulating film 71 made of polyimide or the like is formed in the portions except for conjunction portions 5 of a first semiconductor deice 4. Metal members 70 made of Au or the like are provided for the conjunction portion 5 before flattening exposed surfaces 73 and 72 of the metallic members 70 and the insulating film 71. On the other hand, another insulating film 71′ made of polyimide or the like is formed in the portions except for conjunction portions 5′ of a second semiconductor device 4′. Metal members 70′ made of Au or the like are formed in the conjunction portion 5′ before flattening exposed surfaces 73′ and 72′ of the metal members 70′ and the insulating film 71′.

Then, the first semiconductor device 4 and the second semiconductor device 4′ are, as shown in Fig. 2, positioned and welded so that the conjunction portions 5 of the first semiconductor device 4 and the conjunction portions 5′ of the second semiconductor device 4′ are connected to each other with the metal members 70 and 70′.

The method according to (5) and shown in Fig. 3 is characterized in that:
an anisotropic conductive film 78 is interposed between a first circuit substrate 75 and a second circuit substrate 75′, this anisotropic conductive film 78 being formed by having conductive particles 79 dispersed in an insulating material 77. The first and second circuit substrates 75 and 75′ are then positioned before application of a pressure alone or a combination of a heat and pressure whereby a junction portion 76 of the first circuit substrate 75 and a junction portion 76′ of a second circuit substrate 75′ are connected to each other.

The method according to (6) and shown in Fig. 4 is characterized in that:
an elastic connector 83 designed such that metal wires 82 made of an insulating material 81 formed by arranging metal wires 82 made of Fe or Cu in the same directions is interposed between the first circuit substrate 75 and the second circuit substrate 75′. The first circuit substrate 75 and the second circuit substrate 75′ are then positioned before being pressurized whereby the conjunction portion 76 of the first circuit substrate 75 and the conjunction portion 76′ of the second circuit substrate 75′ are connected to each other.

However, the above-described conventional bonding method involves the following problems:
a circuit design on the basis of the bonding method involves a certain limitation. The pitch (the distance between the central portions of the neighboring junctions) between the neighboring conductors is too large, and the overall thickness of the circuit cannot be reduced. In addition, the reliability is insufficient because of corrosion and breakage of the conductor, and the characteristics can deteriorate due to the concentration of heat in the portions between the bonding members and the electric circuit members. Furthermore, if an electric circuit part becomes defective, it cannot be solely replaced.

The art shown in Figs. 1 and 2 arises the following problems:
(a) The the exposed surface 72 of the insulating film 71 and the exposed surface 73 of the metallic members 70 or the the exposed surface 72′ of the insulating film 71′ and the exposed surface 73′ of the metallic member 70′ needs to be flattened. Therefore, its manufacturing cost will rise due to increase in the manufacturing process.
(b) If there were any level difference between the exposed surface 72 of the insulating film 71 and the exposed surface 73 of the metallic members 70 or between the exposed surface 72′ of the insulating film 71′ and the exposed surface 73′ of the metallic member 70′, the metallic members 70 and 70′ cannot be connected to each other, causing reduction in reliability of the electric circuit.

The art according to (5) and shown in Fig. 3 arises the following problems:
(a) When the conjunction portions 76 and 76′ are connected to each other by application of a pressure after thet have been positioned, the connected portions become unequal in the connection state since the pressure cannot be applied equally. As a result, the resistance of the conjunction portions caused from contact also becomes unequal. This leads to the deterioration in the reliability in the connection established. In addition, if a large amount of electric current is allowed to pass through the circuit, the junction portions adversely generate heat. Therefore, this art cannot be suitably used in a case where a large amount of electric current is intended to be allowed to pass.
(b) Even if a pressure is applied equally to the conjunctions portions 76 and 76′, the resistance distribution becomes unequal due to the configurations of the conductive particles 79 of the anisotropic conductive film 78. It leads to the deterioration in the reliability in the connection established. In addition, this art cannot be suitably used in a case where a large amount of electric current is intended to be allowed to pass.
(c) Since the resistance between the neighboring conjunction portions can be reduced by shortening the pitch between the neighboring conjunction portions (the distance between the center portions of the neighboring conjunction portions), it is not suitably used in dense connections.
(d) Since the resistance can be varied by the unequal projection h1 of the conjunction portions 76 and 76′ of the circuit substrates 75 and 75′, it needs for the unequal amount in projection h1 to be restricted.
(e) Furthermore, if the anisotropic conductive film were employed to connect the semiconductor devices and the circuit substrate or to connect the first semiconductor devices and the second semiconductor devices, a bump needs to be provided for each conjunctions portion of the semiconductor device, causing the overall cost to be raised.

In addition, when the art according to (6) and shown in Fig. 4 is employed to connect semiconductor devices and a circuit substrate or to connect the first semiconductor devices and the second semiconductor devices, the following problems (a) to (d) arise:
(a) Since a pressure needs to be applied to the conjunction portions, a pressurizing tool needs to be used.
(b) Since the contact resistance between the metal wire 82 of the elastic connector 83 and the conjunction portion 76 of the first circuit substrate 75 and the conjunction portion 76′ of the second circuit substrate 75′ can be varied due to the pressure applied and the surface condition, the reliability in connection is insufficient.
(c) Since the metal wire 82 of the elastic connector 83 is made of a rigid material, each surface of the elastic connector 83, the first circuit substrate 75, and the second circuit substrate 75' can be broken if the applied pressure is to large. On the other hand, if the applied pressure is to small, the reliability in connection is insufficient.
(d) In addition, the projection h2 of the conjunction portions 76 and 76' of the circuit substrate 75 and 75', the projection h3 of the metal wire 82 of the elastic connector 83, and their unequal level can influence the change in the resistance and the breakage. Therefore, any countermeasure for reducing the unequal projection needs to be taken.

According to the document EP-A-0 245 179 there is known a generic system for detachably mounting semiconductors on a conductor substrate according to the preamble of the claim. This is achieved without soldering by pressing an anisotropic conductor pad between a semiconductor die and a conductor substrate. The apparatus disclosed in this document comprises for alignment purposes a nest plate which has apertures arranged in a pattern corresponding to the pattern of the contact regions of the other electric circuit component. The apertures define receptacles for receiving the electric circuit components and the electrically connecting member in order to achieve alignment between the electric circuit components at the one end portion of the electrically conductive members and the other electric circuit component at the other end portion. However, when the system is mounted, the alignment between the contact regions of the other electric circuit component and the apertures of the nest plate has to be performed precisely. Any positional error will inevitably lead to wrong connections of every circuit component.

It is the object of the present invention to provide an electric circuit apparatus which ensures proper alignment of the holding member, the electrically connecting member and the other electric circuit, wherein these elements are readily replacable and the conjunctions portions therebetween exhibit excellent reliability.

This object is achieved by means of the features of the claim.

In the following, the invention is illustrated by an embodiment referring to the figures.
Figs. 1 to 4 are cross-sectional views which illustrate a conventional example;
Figs. 5A to 5D are cross-sectional views which illustrate an embodiment according to the invention;
Figs. 6A to 6D are cross-sectional views which illustrate an embodiment of the method of metallizing and/or alloying according to the embodiment;
Figs. 7A to 7C are cross-sectional views which illustrate an embodiment of the method of metallizing and/or alloying according to the embodiment;
Figs. 8A to 8C are a cross-sectional view and perspective views which illustrate a method of manufacturing an electrically connecting member for use in the embodiment;
Figs. 9A to 9C are cross-sectional views which illustrate the process for manufacturing the electrically connecting member used in the embodiment;
Figs. 10A and 10B are cross-sectional views which illustrate the states before and after the connection according to the embodiments.

First, essential components of the present invention will be respectively described.

### Electric circuit components

The electric circuit components according to the present invention are exemplified by: semiconductor elements such as transistors and ICs, circuit substrates such as resin circuit substrates, ceramic substrates, metal substrate, silicon substrates (sometimes abbreviated to "circuit substrate" hereinafter), and lead frames.

The electric circuit components to be held by or connected to the electric circuit components holding member may be arranged to be present solely on a surface of the electric circuit holding member or a plurality of the same may be present on a surface. The size, shape, and type of the electric circuit components to be held or connected by the electric circuit component holding member may be optionally determined. However, the more the number and the types of the electric circuit components to be held or supported by the electric circuit component holding member increases, the greater the effect obtainable from the present invention becomes considerable.

The electric circuit components to be connected to the electrically connecting components holding may be arranged to be present solely on a surface of the holding member or a plurality of the same may be present on a surface.

Electric circuit components having connecting portions are the subject of the present invention. Although the number of the connecting portions may be optionally determined, the more the number of them increases, the greater the effect obtainable from the present invention becomes considerable.

In addition, although the positions at which the connecting portions are disposed may be optionally determined, the inner the connecting portion are present in the electric circuit components, the greater the effect obtainable from the present invention becomes considerable.

The connecting portions are made of electrically conductive material.

### Electric circuit component holding member

The electric circuit component holding member may be made of any material selected from metal, alloy, organic and inorganic materials. Alternately, a material obtained by composing of the above-described materials may be employed. The shape and size of the electric circuit holding member may be optionally determined if a connection between the electric circuit components to be held or connected and the corresponding electric circuit components can be equally and stably established.

Although the size, the number, and the types of the electric circuit components to be held by or connected to the electric circuit component holding member may be optionally determined, the more the number and the types of them increases, the greater the effect obtainable from the present invention becomes considerable.

The above-described metal or alloy is exemplified by: metal or alloy such as Ag, Cu, Al, Be, Ca, Mg, Mo, Fe. Ni, Co, Mn, W, Ti, Pt, Cr, Pd, Nb, Ta, V, and Y.

The inorganic material is exemplified by: Si, Ge, GaAs, InGaAsp, InP, and a-Si semiconductors; B₂O₃, Al₂O₃, Na₂O, K₂O, CaO, ZnO, BaO, PbO, Sb₂O₃, As₂O₃, La₂O, ZrO₂, BaO, P₂O₅, TiO₂, MgO, SiC, BeO, BP, BN, h-BN, c-BN, AlN, B₄C, TaC, TiB₂, CrB₂, TiN, Si₃N₄, Ta₂O₅, and SiO₂ ceramics, Ia, Ib, IIa, and IIb diamonds, glass, synthetic quartz, carbon, boron, and the other inorganic materials.

The organic material may employ, for example, insulating resin that is exemplified by thermosetting resin, ultraviolet curing resin, and thermoplastic resin, exemplified by: polyimide resin, polyphenylene sulfide resin, polyether sulfon resin, polyether imide resin, polysulfon resin, fluororesin, polycarbonate resin, polydiphenylether resin, polybenzil imidazole resin, polyamideimide resin, polypropylene resin, polyvinyl chloride resin, polystylene resin, methacrylate metyl resin, polyphenylene oxide resin, phenol resin, melanin resin, epoxy resin, urea resin, methacrylic resin, vinylidene chloride resin, alkid resin, silicon resin.

A circuit may be formed in the electric circuit component holding member according to the present invention. When the electric circuit component holding member is made of an insulating material or a material whose surface has been subjected to the insulating treatment, a circuit pattern and a conjunction portion may be formed on at least a side of the electric circuit component holding member. Alternately, the circuits may be connected to each other on the two sides of the holding member, or holding bodies on which a circuit pattern has been respectively drawn may be layered to form a multilayered substrate.

As the electric circuit component holding member, a layered structure may be employed that can be obtained by combining materials each of which exhibits individual functions. For example, a combination of a circuit substrate and a reinforcing plate or a combination of a circuit substrate and radiating fins may be employed. The number of the layers and the functions may be selected optionally.

### Electrically connecting member

The electrically connecting member according to the present invention is formed such that a plurality of conductive members are embedded in a holding body made of an electrically insulating material. The conductive members are electrically insulated from each other.

An end of this conductive member appears on one side of the holding member, while another end of the same appears on the other side of the holding member.

The electrically connecting members may be formed by a single layer or a multilayer consisting of two or more layers.

### Conductive member

It is preferable for the metal component to be made of gold. However, the following metal or an alloy may be optionally employed, which is exemplified by: metal or an alloy such as Ag, Be, Ca, Mg, Mo, Ni, W, Fe, Ti, In, Ta, Zn, Cu, Al, Sn, and Pb-Sn.

The metal member and the alloy member may be arranged such that one electrically connecting member may include the same metals or may include individual type metals. Each of the metal members and the alloy members of the electrically connecting member may be made of the same metals or alloys, and alternately the same may be made of individual metals or alloys. A material prepared by an organic material and/or inorganic material contained in a metal material may be employed if it displays conductivity. A material obtained by combining an inorganic material and an organic material may be employed if it displays conductivity.

The cross-sectional shape of the electrically conductive member may be formed in a circular, rectangular, or other optional shapes.

The thickness of the electrically conductive member is not specifically limited, but it is preferable for the same to be 20 µm or more, and it can be 20 µm or less.

The portion of the electrically conductive member that appears outside may be arranged to be the same level as that of the holding body, or it may be arranged to project over the surface of the holding body. This projection portion may be formed on one side or on two sides. When the projection arranged to further project, it may be formed in a bump-like shape.

The interval between the electrically conductive members may be arranged to be the same interval between the conjunction portions of the electric circuit parts, or the same may be arranged to be an interval which is shorter than the former. When a shorter interval is employed, the electric circuit components and the electrically connecting members can be connected to each other without any necessity of performing any positioning of the electric circuit components and the electrically connecting components.

It does not need for the electrically conductive member to be arranged to be perpendicular to the holding body, but it may be diagonally arranged from one side of the holding member to another side of the same.

### Holding body

The holding body is made of an electrically insulating material.

Any electrically insulating material may be employed. The electrically insulating material may be exemplified by an organic material and an inorganic material. Alternately, a metal or an alloy which has been subjected to a treatment in which the electrically conductive members are electrically insulated from each other may be employed. One type or a plurality of types of inorganic, metal or alloy in the form of desired shapes such as pulverulent and fiber may be dispersed and contained in the inorganic materials. In the case where the holding member is made of a metal, it needs, for example, for an electrically insulating material such as resin to be disposed between the electrically conductive material and the holding body.

For example, insulating resin such as thermosetting resin, ultraviolet curing resin and thermoplastic resin may be employed as the organic material, the insulating resin being exemplified by: polyimide resin, polyphenylene sulfide resin, polyether sulfon resin, polyether imide resin, polysulfon resin, fluororesin, polycarbonate resin, polydiphenylether resin, polybenzil imidazole resin, polyamideimide resin, polypropylene resin, polyvinyl chloride resin, polystylene resin, methacrylate metyl resin, polyphenylene oxide resin, phenol resin, melanin resin, epoxy resin, urea resin, methacrylic resin, vinylidene chloride resin, alkid resin, silicon resin.

It is preferable to select resin that exhibits excellent thermal conductivity from the above-described materials since heat which has been inevitably generated by the semiconductor device can be discharged through the resin. In addition, deterioration in reliability of the apparatus due to thermal expansion and thermal contraction can be further prevented by arranging the structure such that resin that displays the same or substantially the same thermal expansion coefficient as that of the circuit substrate is selected and at least one hole or a plurality of air bubbles are arranged to be disposed in the organic material.

The inorganic material and the metal material to be employed is exemplified by: SiO₂, B₂O₃, Al₂O₃, Na₂O, K₂O, CaO, ZnO, BaO, PbO, Sb₂O₃, As₂O₃, La₂O₃, ZrO₂, BaO, P₂O₅, TiO₂, MgO, SiC, BeO, BP, BN, AlN, B₄C, TaC, TiB₂, CrB₂, TiN, Si₃N₄, Ta₂O₅ ceramics, and metal or an alloy such as Ag, Cu, Au, Al, Be, Ca, Mg, Mo, Fe, Ni, Si, Co, Mn, and W.

### Connection: connection established by metallizing and/or allowing

The end portion of the electrically connecting member can be connected to the electric circuit component by the following method, wherein the method is structured such that each of the end portions of the plurality of electrically conductive members which appear on the one side of the holding body and at least one of the plurality of conjunction portion of the other electric circuit component are connected to each other via a conjunction layer formed by being metallized or alloyed, while the other end portions of a plurality of electrically conductive members which appear on the other side of the holding body and a plurality of conjunction portions of the other electric circuit components are connected to each other via a conjunction layer formed by metallizing and/or alloying.

The conjunctions layers will be described.

In a case where the electrically conductive member and the conjunction portion which are to be connected to each other are made of the same pure metal, the conjunction layer to be formed due to metallization becomes a crystalline structure of the same type that forms the electrically conductive member or the conjunction portion. In order to perform the metallization, a method may, for example, be employed which is arranged such that the end portions of the electrically conductive member and the corresponding conjunction portion which have been brought into contact into each other are heated up to a proper temperature. As a result of this heat, atoms can diffuse in the vicinity of the contact portion, causing the diffused portion to be brought to a metallized state and the conjunction layer is formed.

In a case where the electrically conductive material and the conjunction portion to be connected to each other are made of individual pure metals, the thus-formed conjunction layer are made of an alloy of the above-described metals. In order to perform this alloying, a method may, for example, be employed which is arranged such that the end portion of the electrically conductive member and the corresponding conjunction portion which have been brought into contact into each other are heated up to a proper temperature. As a result of this heat, atoms can diffuse in the vicinity of the contact portion, causing a layer made of a solid solution or a metallic compound to be formed in the vicinity of the contact portion, this layer being able to serve as the conjunction layer.

In the case where Au is employed as the metal forming the electrically connecting member and Al is employed in the conjunction portion of the electric circuit components, it is preferable for the heating temperature to be arranged to 200 to 350 °C.

In the case where either of the electrically conductive member or the conjunction member is made of a pure metal while the other one is made of an alloy, or in the case where both of them are made of the same or the individual alloys, the conjunction layer is made of the alloy.

In any of the following cases, the above-described metallization or alloying is performed, and the conjunction portion is treated similarly: a case where the plurality of electrically conductive members of a electrically connecting member are made of the same metal or alloy, a case where the same are respectively made of individually metals or alloys, a case where one electrically conductive member is made of the same metal or alloy, a case where one electrically conductive member is made of individual metal or alloy.

The electrically conductive member or the conjunction portion needs to be made of metal or alloy in the contact portion therebetween, and the other portions may be made of a material in which glass is mixed with metal or resin is mixed with metal.

It is preferable for improvement in strength of the connected portion to reduce the surface roughness of the portions to be connected to each other (preferably be 0.3 µm or less). Furthermore, a plating layer made of metal or alloy that can be readily brought to an alloy may be formed on the surfaces to be connected to each other.

### Holding

The following methods (1) to (5) may be employed to hold at least one side other than the sides on which at least one electrically connecting portion is present of the electric circuit component holding member and the electric circuit component and to hold the electrically connecting member and the electric circuit component or the other electric circuit component, where at least one portion of the above needs to be held by at least one of the following methods:
(1) A holding method in which the setting reaction of organic material is utilized. When resin is used as the organic material, the type of it can be optionally selected. For example, any material selected from a group consisting of thermosetting resin and ultraviolet curing resin may be employed.
(2) A holding method in which an adhesive is used. The type of the adhesive is optionally selected. For example, any material selected from a group consisting of acrylic adhesive and epoxy adhesive may be employed.
(3) A holding method in which the above-described metallization and/or alloying is employed.
(4) A holding method in which the portions of the electric circuit holding member and that of the electric circuit component are made of the same material, the surfaces of these portions are cleaned, the thus-cleaned surfaces are stacked to each other in vacuum so that they are held by a force (Van der Waals forces) between the component atoms of the contact portion.
(5) A optional method other than (1) to (4) with a strength as to prevent the positional error of the holding portion even if a certain outer force is applied to the electric circuit holding member or the electric circuit component. For example, mechanical press fitting or the like can be employed.

### Attachment and detachment

The following method is employed to arrange either of the electric circuit component or the other electric circuit component to be an attachable or detachable component:

The method for connecting the electric circuit component and the other electric circuit components to each other in which the portion forming an end of the electrically conductive member which appear on one side of the electrically connecting member and the other ends of the electrically conductive member which appear on the other surface employs individual electrically connecting members made of materials each of which has an individual melting point. According to this, both the electric circuit component and the other electric circuit component are simultaneously connected to each other by metallizing and/or alloying by a heat exceeding the higher melting point of the electrically conductive member which forms an end of the electrically connecting member after the electric circuit holding member, the electric connecting member, and the other electric circuit component have been simultaneously positioned. Alternately, a method may be employed in which either the holding body or the electrically connecting member or either the electrically connecting member or the other electric circuit component is previously positioned as to be connected to each other by metallizing and/or alloying, and they are connected to each other by metallizing and/or alloying by heating them at a temperature exceeding the melting point of the one end of the electrically conductive member and the other end of the same but lower than the melting point of the other one after the other one has been positioned. In the latter case, either the one end or the other end of the electrically conductive member to be previously connected is made of a material having the higher melting point.

There is a method arranged such that when the thus-manufactured electric circuit apparatus is again heated up to a temperature exceeding the lower melting point but below the higher melting point, only the electric circuit component connected to the electrically conductive member of the lower melting point is separated from the electrically connecting member, and then, by heating the apparatus up to a temperature exceeding the lower melting point but below the higher melting point after performing the positioning again, the connection is established by again metallizing and/or alloying. If the positional relationship of the conjunction portions does not changed, electric circuit component which is the same as the electric circuit component which has been previously connected may be connected, and alternately, a different electric circuit component may be connected.

### Mechanical portion or functionating portion which serves as a reference for clarifying the positional relationship

As mechanical portions or functionating portions which serve as references for positioning the electric circuit component holding member and the other electric circuit component and which are disposed in these electric circuit component holding member and the other electric circuit component, positioning holes, positioning pins are employed.

In addition, mechanical portions or functionating portions which serve as positioning references to be provided for the electric circuit component holding member, the other electric circuit components and electrically conductive member may be disposed in the central portion or the peripheral portion. However, the longer the interval between the reference portions, the positional accuracy can be improved. The number of the same is not limited.

Since the electric circuit component is arranged to be attached to or detached from the electrically connecting member, the electric circuit components can be replaced at the time of a failure, causing an electric circuit apparatus which can be extremely readily maintained to be obtained.

As a result of the uniform positional relationship between the conjunction portions, the electric circuit component to be held by or connected to the electric circuit component holding member can be readily connected to the other electric circuit component, and a sole electric circuit apparatus can be given a variety of functions whenever the electric circuit component holding member which holds the electric circuit component or which is connected to the electric circuit component is replaced.

Since the above-described replacement can be performed, even an electric circuit component of the electric circuit apparatus which has been determined as a defective part at the characteristic test after manufacturing can be employed again in the manufacturing process of the electric circuit apparatus. As a result, manufacturing yield can be improved, and thereby the manufacturing cost can be reduced.

Since the electric circuit component and the other electric circuit component are connected to each other by using the above-described electric circuit component holding member and the electrically connecting member, the conjunction portion of the electric circuit component can be disposed in the periphery portion and as well in the portion other than this periphery portion. As a result, the number of the conjunction portions can be increased, causing a dense structure to be achieved.

In addition, since the quantity of the metal material to be used for the electrically connecting member can be reduced, the overall cost can be reduced even if expensive gold is used as the metallic portion.

Since the electric circuit component and the other electric circuit component are connected to each other by the electrically connecting member after the electric circuit component has been held by or connected to the electric circuit component holding member, a plurality of and a variety of electric circuit components can be used. In addition, since the connection of the thus-employed electric circuit components is achieved collectively, a variety of electric circuit apparatuses can be manufactured in one manufacturing process.

By classifying the electric circuit components to be held by the holding member on the basis of their functions, the electric circuit components can be arranged on the basis of the function groups of the holding members holding or connecting the electric circuit components. Therefore, a further various electric circuit apparatuses can be manufactured from the same manufacturing process.

In addition, since the electric circuit components are held by the electric circuit holding member, the electric circuit components do not need to be held by jigs and/or tools during and after completion of the manufacturing the electric circuit apparatus. As a result, control of manufacturing of the electric circuit apparatuses and the same after the manufacturing can be readily performed.

Since the electric circuit component and the other electric circuit component are connected to each other with the electrically connecting member after the electric circuit component has been held by the electric circuit component holding member, it does not need to perform complicated positionings of a surface down mount for each of the electric circuit components, and positioning of the conjunction portions of a multiplicity of electric circuit components can be performed. As a result, manufacturing yield can be significantly improved.

Since the electric circuit component and the other electric circuit component are collectively positioned and connected to each other with the electrically connecting member after the electric circuit component has been held by the electric circuit component holding member, a variety of electric circuit components can be employed, and the connection of the thus-employed electric circuit components can be simultaneously performed. As a result, a variety of electric circuit apparatuses can be manufactured from the same manufacturing process.

The electric circuit components can be connected to a multiplicity of sides of the electric circuit component and the electrically connecting member. As a result, 3-D dense electric circuit apparatus can be obtained.

When a material exhibiting an excellent thermal conductivity is employed as the electric circuit component holding member, and/or when a material exhibiting an excellent thermal conductive is employed as the insulating material of the electrically conductive member, heat generated from the electric circuit component can be further quickly discharged outside. As a result, an electric circuit apparatus exhibiting an excellent heat discharging characteristics can be obtained.

When the insulating body of the electrically conductive member is made of a material with a thermal expansion coefficient approximated to that of the electric circuit component, or when the electric circuit component holding member is made of a material with a thermal expansion coefficient approximated to that of the electric circuit component, any generation of thermal stress and strain can be prevented. As a result, defects which deteriorate the reliability of the electric circuit apparatus such as cracking of the electric circuit components or change in the characteristics of the electric circuit components due to the application of heat can be prevented. As a result, a reliable electric circuit apparatus can be obtained.

Since the plurality of electric circuit components are connected to each other by a conjunction layer formed by metallizing and/or alloying via the electrically connection member, the electric circuit components are strongly and assuredly connected to each other. It leads to a fact that in an electric circuit apparatus the resistance at the conjunction portion of which can be made equal and reduced, and the mechanical strength of which is great, and which exhibits an extremely reduced defective ratio can be obtained.

In addition, since a plurality of electric circuit components are, with the electrically connecting member, connected to each other by a conjunction layer formed by metallizing and/or alloying, the resistance at the conjunction portion between the electric circuit components is further reduced with respect to the case where only one electric circuit component is connected by metallizing and/or alloying.

According to the present invention, the positioning means provided for the electric circuit component holding member, the other electric circuit components, and the electrically connecting members and capable of serving as references for the positional relationship. As a result, the positioning of the electric circuit component holding member and the other electric circuit components can be accurately achieved. That is, the conjunction portion between the electric circuit components held or connected by the electric circuit component holding member and the conjunction portion of the other electric circuit components can be further accurately positioned. As a result, a further precise connection can be widely equally and stably achieved. In addition, the connection can be performed at a high speed. Since a mechanically-fitting type is used as the mechanical portion which serves as the reference for the positional relationship, connection can be simply performed without any positioning. In addition, the connection is established after the positioning has been achieved accurately, the strength distribution of the connected portions can be significantly uniformed. As a result, reliability is improved.

As a result of the arrangement performed such that the electric circuit component holding member serves as a cap for sealing the electric circuit component, heat generated from the electric circuit component can be further quickly discharged outside. Therefore, an electric circuit apparatus exhibiting an excellent heat discharge performance can be obtained. In addition, as a result of the fact that the electric circuit components are sealed from the outside, water invasion into the apparatus can be protected. Consequently, the circuit portion of the conjunction portions and the electric circuit components can be protected from any corrosion, causing its reliability to be improved.

Since the functionating portions of the conjunction portions and the electric circuit components are sealed in a hollow state, any generation of thermal stress or strain due to the difference in the thermal expansion coefficient can be prevented even if the size of the apparatus is enlarged. As a result, defects which deteriorate the reliability of the electric circuit apparatus such as cracking of the electric circuit components or change in the characteristics of the electric circuit components due to the application of heat can be prevented. As a result, a reliable electric circuit apparatus can be obtained.

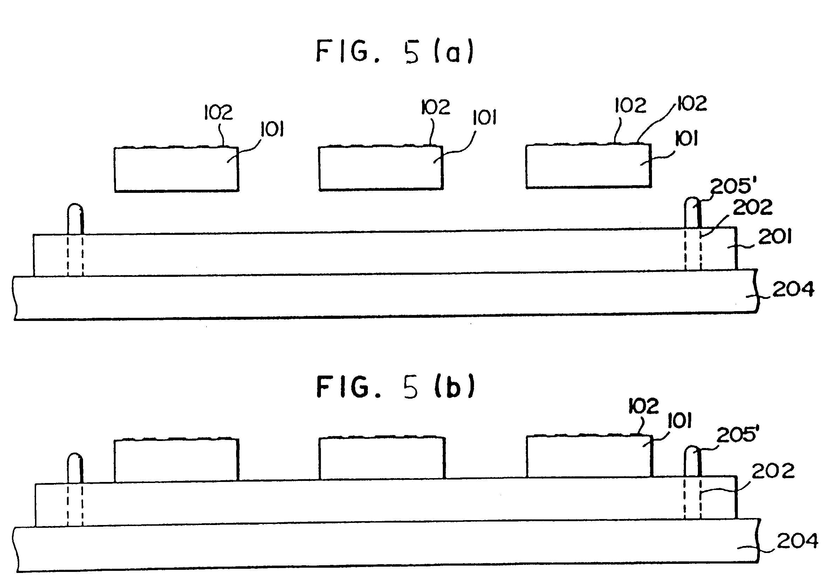

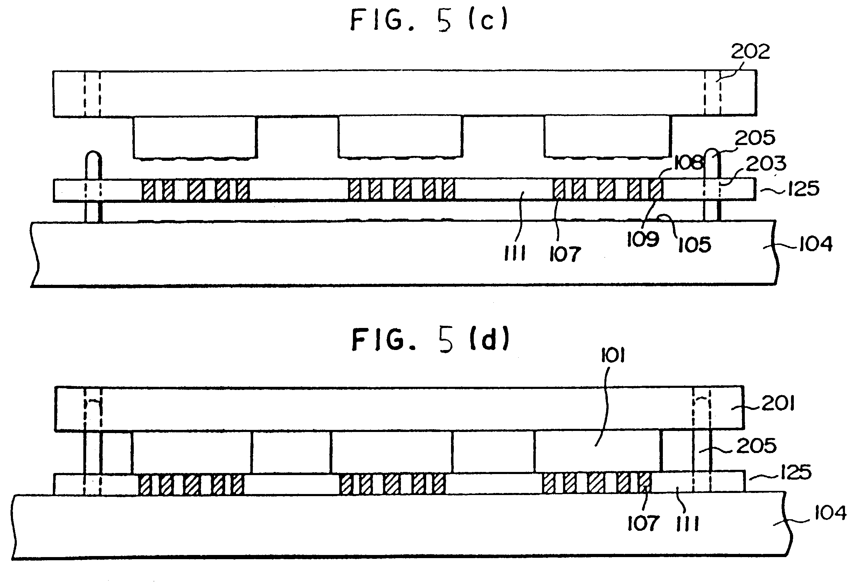

An embodiment of the invention will be described with reference to Figs. 5A to 5D.

A cross-sectional view Fig. 5A is a view which illustrates a state before the plurality of semiconductor devices 101 serving as electric circuit components are connected to and/or held by electric circuit component holding member 201. Reference numeral 204 represents a positioning jig and having a positioning pin 205'. The number of the semiconductor devices 101 may be optionally determined if it exceeds one.

Fig. 5B is a view which illustrate a state after the semiconductor devices 101 have been connected to and/or held by the electric circuit component holding member 201. Fig. 5C is a view which illustrates a state where the semiconductor devices 101 connected to and/or held by the electric circuit component holding member 201 and the circuit substrate 104 serving as the other electric circuit component are made confront each other with an electrically connecting member 125.

In the electrically connecting member 125, metal members 107 serving as the electrically conductive members are embedded in a holding body 111 made of an organic material, end portions of the metal members 107 appear on one side of the holding body 111, the other end portions 109 of the metal members 107 appear on the other side of the holding body 111, and positioning holes 203 are formed.

The electric circuit component holding member 201 comprises a glass plate and holds, by an adhesion force, at least one side of each of the semiconductor devices 101 on which the at least one or more conjunction portions 102 are not present, positioning holes 202 being formed therein.

The semiconductor devices includes conjunction portions 102 at which the semiconductor devices are connected to one end portions 108 of the metal members 107 which appear on one side of the holding body 111 by alloying.

The circuit substrate 104 includes conjunction portions 105 at which the circuit substrate 104 are connected to the other end portions 109 of the metal members 107 which appear on the other side of the holding body 11 by alloying, positioning pins being formed therein.

Fig. 5D is a cross-sectional view which illustrates a state in which the above-described components are integrated by the connection.

The positioning holes 202 and 203 and the positioning pins 205 are the mechanical portions or the functionating portions which serve as reference for the positional relationship.

This embodiment will be in detail described.

As shown in Fig. 5A, after the positioning pins 205' of the positioning jig 204 have been inserted into the positioning holes 202 formed in the glass substrate 201, the semiconductor devices 101 are, by using the positioning pins 205' as the references, positioned as to establish a designed positional relationship between the conjunction portions 102 of the semiconductor devices 101 and the conjunction portions 105 of the circuit substrate 104 as to be held by the glass substrate 201 by an adhesive.

Then, as shown in Fig. 5A, after the positioning pins 205 provided for the positioning jig 204 have been inserted into the positioning holes 202 formed in the glass substrate 201, the semiconductor devices 101 are positioned as to establish a designed positional relationship between the conjunction portions 102 and the conjunction portions of the circuit substrate 104 to be held with an adhesive (see Fig. 5A and 5B).

The thus-manufactured electric circuit component holding member 201 is removed from the holding position determining jig 204, and then the electrically connecting member 125 and the circuit substrate 104 are prepared.

Each of the semiconductor devices 101 and the circuit substrate 104 according to this embodiment includes a plurality of the conjunction portions 102 and 104.

The conjunction portions 102 of the semiconductor devices 101 are arranged such that the metal appears at the positions which correspond to the conjunction portions 105 of the circuit substrate 104 and the conjunction portions 108 and 109 of the electrically connecting member 125.

As shown in Fig. 5C, the positioning pins 205 provided for the circuit substrate 104 are inserted into the positioning holes 203 formed in the electrically connecting member 125, and then these positioning pins 205 are inserted into the positioning holes 202 formed in the electric circuit component holding member 201 so that the positioning is completed. Then, as shown in Fig. 5, a connection between the conjunction portions 102 of the semiconductor devices 101 and the conjunction portions 108 of the electrically connecting member 125 and a connection between the conjunction portions of the circuit substrate 104 and the conjunction portions of the electrically connecting member 125 are established by metallizing and/or alloying.

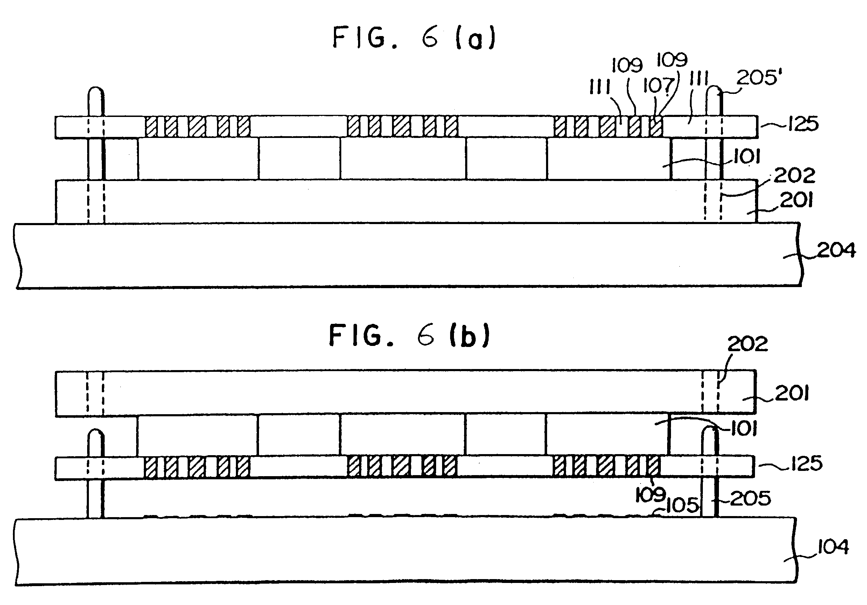

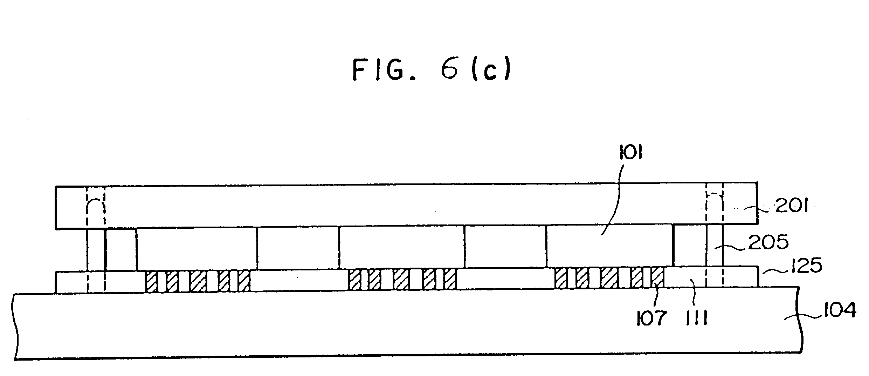

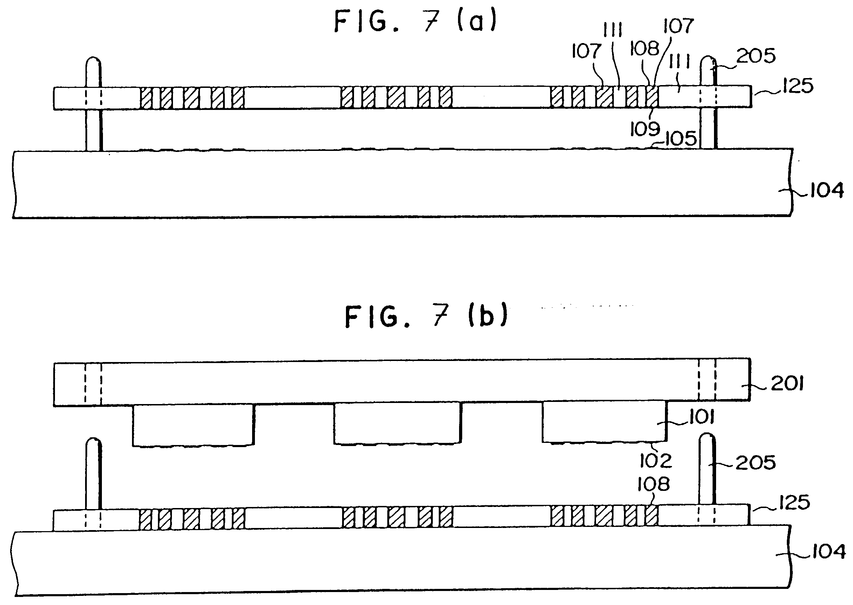

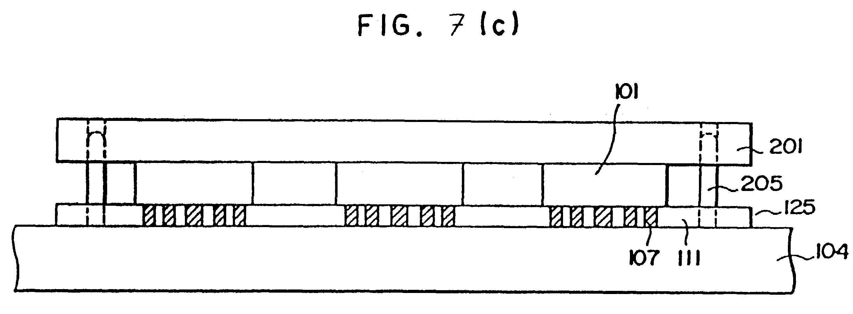

Any of the following three methods can be employed to connect the semiconductor devices 101, the electrically connecting member 125, and the circuit substrate 104 by metallizing and/or alloying.
(1) A method in which, after the glass substrate 201, the electrically connecting member 125 and the circuit substrate 104 have been positioned, a connection between the conjunction portions 102 of the semiconductor devices 101 and the conjunction portions 108 of the electrically connecting member 125 and a connection between the conjunction portions 105 of the circuit substrate 104 and the conjunction portions 109 of the electrically connecting member 125 are established by metallizing and/or alloying.
(2) A method in which the glass substrate 201 and the electrically connecting member 125 are positioned, and then the conjunction portions 102 of the semiconductor devices 101 and the conjunction portions 108 of the electrically connecting member are connected to each other by alloying. Then, the circuit substrate 104 is positioned as to establish a connection between the conjunction portions 109 of the electrically connecting member 125 and the conjunction portions 105 of the circuit substrate 104 is established by metallizing and/or alloying (see Fig. 6A to 6C).
(3) A method in which the circuit substrate 104 and the electrically connecting member 125 are positioned, and the conjunction potions 105 of the circuit substrate 104 and the conjunction portions 109 of the electrically connecting member 125 are connected to each other by metallizing and/or alloying. And then, the glass substrate 201 is positioned and the conjunction portion of 108 of the electrically connecting member 125 and the conjunction portions 102 of the semiconductor devices are connected to each other by
   metallizing and/or alloying (see Figs. 7A to 7C).

According to this embodiment, although the position pins 205 are provided for the circuit substrate 104, it is apparent that a similar effect can be obtained even if the same is provided for the glass substrate 201 which serves as the electric circuit holding member. In addition, a structure may be employed which is arranged such that positioning holes are formed in both the glass substrate 201 serving as the electric circuit holding member and the circuit substrate 104 and the positioning pins are provided for both the same. In addition, a similar effect can be obtained from a structure arranged such that the positioning holes are formed in both the glass substrate and the circuit substrate but the positioning pins are not provided for both. Alternately, the positioning pins are provided for the connecting position determining jig similarly to the manner in which the pins are provided for the holding position determining jig used in Figs. 5A and 5B.

When the connection of the conjunction portions of the thus-manufactured electric circuit apparatus has been examined, excellent reliability was exhibited.

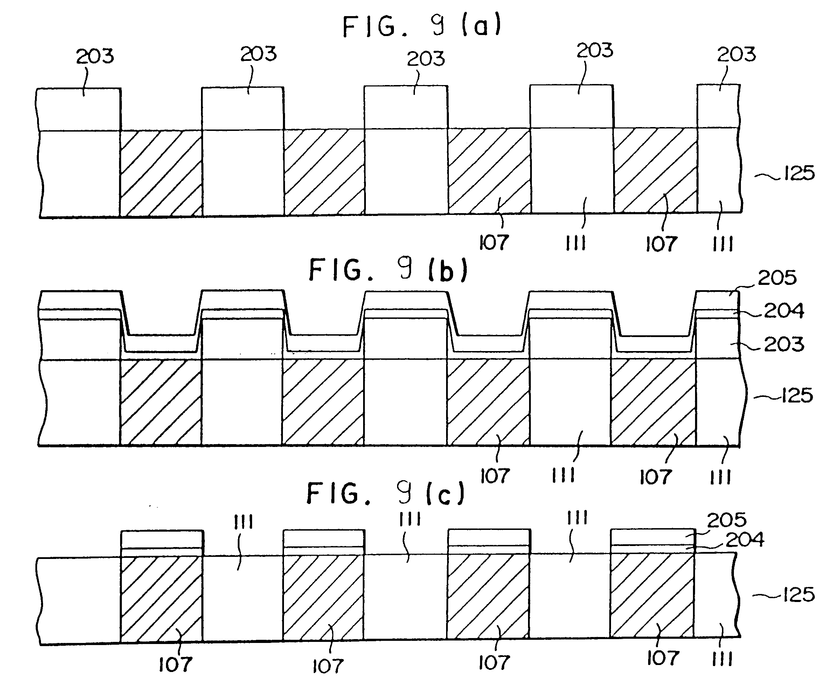

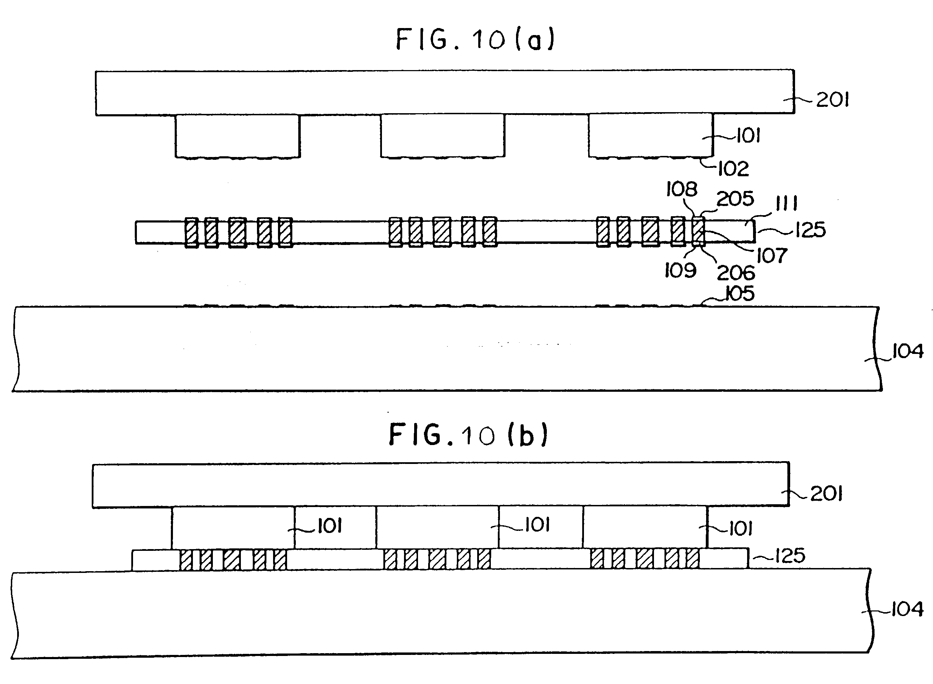

According to Figs. 9A-9C and Figs. 10A and 10B, an electrically connecting member is employed which is designed such that the metal members which appear on one side of the electrically connecting member 125 and the metal members which appear on the other side are made of material which have individual melting points.

An example of manufacturing this electrically connecting member will be described.

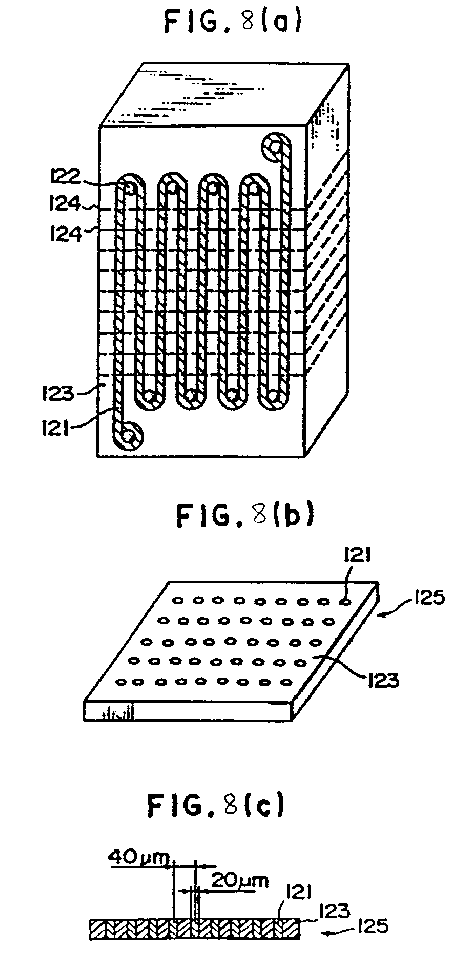

An electrically connecting member 125 shown in Figs. 8B and 8C is prepared by the method according to the first embodiment. Resists 203 are, as shown in Fig. 9A, formed by a photo-litho method in the portions in which no metal members 107 appears in one side of this electrically connecting member 125. Then, a diffused barrier layer 204 made of Mo, W, Pd or the like is formed by spattering. An Au-Sn (20 wt%) layer is formed on this barrier layer 204 (see Fig. 9B), and the resists 203 are removed by a lift-on method (see Fig. 9C). Then, the barrier layer 204 and a Pb-Ag-Sn (36.1-1.4-62.5 wt%) layer 206 (omitted from the illustration in Figs. 9A to 9C) are formed on the other side of the electrically connecting member. The thus-manufactured electrically connecting member 125 is arranged, at the two ends of the metal members 107 thereof, such that the Au-Sn (20 wt%) layer displays a melting point of 280 °C while the Pb-Ag-Sn (36.1-1.4-62.5 wt%) layer displays a melting point of 180 °C, in which the difference in the melting point becomes substantially 100 °C.

The above-described electrically connecting member 125 is, as shown in Figs. 10A and 10B, heated up to 300 °C or higher and compressed after positioning the glass substrate 201 holding the semiconductor devices 101, the electrically connecting member 125 and the circuit substrate 104. As a result, a connection between the conjunction portions 102 of the semiconductor devices 101 and the conjunction portions 108 of the electrically connecting member 125 and a connection between the conjunction portions 105 of the circuit substrate 104 and the conjunction portions 109 of the electrically connecting member 125 are established by simultaneously metallizing and/or alloying.

In the thus-manufactured electric circuit apparatus, when the same is heated at a temperature higher than the lower melting point but lower than the higher melting point, either conjunction portion is melted, causing for only either component to be removed. On the other hand, when heating the same at a temperature higher than the lower melting point but lower than the higher melting point after the simultaneous positioning, they can be again connected to each other.

According to this embodiment, since the composition ratio can be changed due to the thermal diffusion of metal atoms whenever heating is conducted, the number of the attachment and the detachment is of course limited. However, since the two conjunction portions can be connected to each other by metallizing and/or alloying, the resistance at the conjunction portions can be significantly reduced. As a result, a stable connection can be always obtained.

According to this embodiment, although the Au-Su layer 205 is formed on the end portions 108 of the metal member 107 while the Pb-Ag-Sn layer 206 is formed on the other end portions 109, it can be conducted in a reversed manner. In addition, an alloy layer other than that described above can be employed as the 205 and 206 if proper melting points and a proper difference in temperatures can be obtained.

Since the present invention is structured as described above, the following various advantages can be obtained:
(1) A reliable connection can be obtained in the connection of the electric circuit parts such as connection of the semiconductor devices and the circuit substrates and/or lead frames. Therefore, the conventional methods such as a wire bonding method, a TAB method, and a CCB method and the like can be replaced.
(2) According to the present invention, the conjunction portions of the electric circuit parts can be disposed at any positions desired (particularly in the inner portion). Therefore, a further great number of contacts can be used for the connection with respect to the conventional wire bonding method or the TAB method. Therefore, a system suitable for multi-pin connection can be obtained. In addition, since an insulating material is previously present in the neighboring metals of the electrically conjunction members, electric conduct between the neighboring metals can be prevented. Therefore, a further great number of contacts can be employed with respect to the CCB method.
(3) Since the quantity of the metal used in the electrically connecting members can be reduced with respect to the conventional system, the overall cost can be reduced with respect to the conventional apparatus even if expensive metal such as gold is used as the metal member.
(4) Dense electric circuit apparatus such as semiconductors can be obtained.
(5) Since both of the electric circuit components are connected to each other by a conjunction layer formed by metallizing and/or alloying via an electrically connecting member, the electric circuit components can be strongly and assuredly connected to each other. As a result, mechanically strong electric circuit apparatus exhibiting significantly reduced defection ratio can be obtained.
(6) When the holding body of the electrically connecting member is arranged such that the insulating body thereof is made of either powder or fiber or a material obtained by dispersing both the powder and fiber comprising one or a plurality of metals or inorganic materials exhibiting excellent heat conductivity or the insulating body is made of a metal or an inorganic material whose electrically conductive member can be insulated, heat from the electric circuit components can be discharged though the electrically connecting member or the other electric circuit components. Therefore, an electric circuit apparatus exhibiting excellent heat discharging performance can be obtained.
   When the electric circuit component holding member is formed by sole type of metal or an inorganic material exhibiting excellent heat conductivity, heat from the electric circuit components can be discharge through the electric circuit component holding member. As a result, an electric circuit apparatus exhibiting excellent heat discharging performance can be obtained.
(7) Since the other electric circuit components are connected after the electric circuit component is held by the electric circuit component holding member, the shape of the holding member can be designed to correspond to the electric circuit component to be held. Therefore, the connection can be performed regardless of the size, shape, and the type of the electric circuit component can be performed. Therefore, free and dense mounting can be achieved, causing a free design to be performed.
(8) By classifying the electric circuit components to be held on the basis of their functions, they can be classified into function blocks for the holding members. As a result, variety of electric circuit apparatuses can be obtained from the same manufacturing process, causing the mounting and design to be widely used.
(9) By arranging the structure such that either of the electric circuit component held by the electric circuit component holding member or the other electric circuit component can be attached to or detached from the electrically connecting member, if the electric circuit component or the other electric circuit component is broken, it can be readily replaced. In addition, since the electric circuit components are connected to and/or held by the electric circuit component holding member arranged such that at least one or more sides thereof is formed with the circuits, handling of it can be readily performed. Since the electrically connecting member is held by either of the electric circuit component, positioning required at the time of performing a connection can be readily conducted.
   In addition, the thus-established connection exhibits excellent reliability.
(10) By unifying the positional relationship of the conjunction portions, a connection between the electric circuit component whose function is changed and to be held by the electric circuit component holding member and the other electric circuit component can be readily connected to each other. As a result, whenever the electric circuit component holding member holding the electric circuit component is changed, the same electric circuit apparatus can display another function. Therefore, systematized electric circuit apparatus can be obtained.
(11) The electric circuit components or the other electric circuit components held by or connected to the electric circuit component holding member exhibiting excellent characteristics can be again introduced into the process of manufacturing the electric circuit apparatus even if it is determined as defective at the inspection after the production of the electric circuit apparatus. As a result, manufacturing yield can be improved and manufacturing cost can be reduced.
(12) When a double-sided substrate, multilayered substrate or a substrate in which through holes are formed are employed as the electric circuit component holding member, a multilayered structure can be realized by the same method, and 3-D mounting can be performed. As a result, the signal delay time can be shortened by the reduction in the length of the signal line. Therefore, a high speed electric circuit apparatus can be obtained.
   In addition, the conjunction portions between the electric circuit apparatuses can be significantly reduced, a further small sized apparatus can be manufactured. As a result, product design can be freely conducted.
(13) By arranging the structure such that, after the electric circuit components are connected to and/or held by the electric circuit component holding member on which the circuit is formed, it is connected to the other electric circuit component, a connection regardless of the size, shape and type of the electric circuit components can be achieved. As a result, free and dense mounting can be performed, causing a freedom in design to be significantly improved.
(14) By arranging the structure such that after the electric circuit components are connected to and/or held by the electric circuit component holding member on which the circuits are formed, the other circuits and the electric circuit components are connected, a multilayered structure can be formed by the same method. Therefore, ultradense 3-D mounting can be performed, and the length of the signal lines can be reduced, causing for the involved delay time to be reduced. In addition, the size of the electric circuit apparatus can be reduced, causing a freedom in design to be improved.
(15) By classifying the electric circuit components to be connected to and/or held by the electric circuit component holding member on which the circuits are formed, they can be classified into blocks on the basis of their functions. Therefore, variety types of electric circuit apparatuses can be obtained from the same manufacturing process, causing the probability in a wide use to be significantly improved.
(16) Since the connection can be collectively performed, the more the number of the connecting portions increases, the more reliable connection can be obtained in a short time.
(17) By arranging the structure that the circuits on the electric circuit component holding member are connected to the electrically connecting member as well as the electric circuit components, the considerably high mounting density can be obtained.
(18) By arranging the structure such that the positioning means acting to clarify the positional relationship between the electric circuit component holding member, the other electric circuit components, and the electrically connecting member are provided for the latter, each positioning between the electric circuit component holding member and the electric circuit components, between the electric circuit component holding member and the other electric circuit components, or between the electric circuit component holding member, the electrically connecting member and the other electric circuit components is performed with an addition precision obtained. That is, the positioning between the conjunction portions of the electric circuit components held or connected to the electric circuit component holding member and the position between the same and the electrically conductive members which appear on the two sides of the electrically connecting member can be performed precisely. Therefore, further precise and wide connection can be performed. The advantage of its reduced positional error will dedicate to improve the reliability since the area of connection is maintained constant.
(19) Since mechanical fittings are employed in the electric circuit component holding member, the other electric circuit components, and the electrically connecting member as the reference mechanical portions, the positioning between the electric circuit component holding member,the other electric circuit components, and the electrically connecting member can be readily performed. As a result, the electric circuit components can be connected without any necessity of performing special positioning.
(20) When an insulating material made of a conductive material or made of a material in which the conductive material is uniformly mixed is used as the electric circuit component holding member, an electric circuit apparatus exhibiting a shielding effect can be obtained.

## Claims

1. An electric circuit apparatus comprising:
- an electrically connecting member (125) including a holding body (111) made of an electrically insulating material and a plurality of electrically conductive members (107) embedded in said holding body, wherein first end portions of said electrically conductive members extend through one side of said holding body, while second end portions of said electrically conductive members extend through the other side of said holding body;
- a plurality of first electric circuit components a (101) to which said first end portions of said electrically conductive members are connected;
- a second electric circuit component b (105) to which said second end portions of said electrically conductive members are connected; and
- a base member (104) for supporting said electric circuit component b (105);
- a holding member (201) which holds said plurality of first electric circuit components a (101); and
- positioning means (202, 203, 205, 205') for positioning of said holding member (201) and said base member (104) with said electrically connecting member (125) by inserting positioning projections (205; 205') provided at one of said holding member and said base member into holes (202) provided at the other member
**characterized in that**
said positioning projections penetrate through a plurality of holes (203) in said electrically connecting member; and
- said first electric circuit components a (101), said electric connecting member (125) and said second electric circuit component b (105) are connected by metallising and/or alloging, wherein
said first end portions and said second end portions of said electrically conductive members (107) are made of materials having different melting points.

## Patentansprüche

1. Eine elektrische Schaltungsvorrichtung, die umfaßt:
- ein elektrisch verbindendes Bauteil (125) einschließlich eines aus elektrisch isolierendem Material gefertigten Aufnahmekörpers (111) und einer Mehrzahl von in den genannten Aufnahmekörper eingebetteten elektrisch leitfähigen Elementen (107), wobei sich erste Endstücke der besagten elektrisch leitfähigen Elemente durch die eine Seitenfläche des genannten Aufnahmekörpers hindurch erstrecken, während sich zweite Endabschnitte der besagten elektrisch leitfähigen Elemente durch die andere Seitenfläche des genannten Aufnahmekörpers hindurch erstrecken;
- eine Mehrzahl von ersten elektrischen Schaltungselementen a (101), mit denen die erwähnten ersten Endstücke der besagten elektrisch leitfähigen Elemente verbunden sind;
- ein zweites elektrisches Schaltungselement b (105), mit dem die erwähnten zweiten Endabschnitte der besagten elektrisch leitfähigen Elemente verbunden sind;und
- ein Basisbauteil (104), um das genannte zweite elektrische Schaltungselement b (105) zu tragen;
- ein Halterungsbauteil (201), das die erwähnte Mehrzahl von ersten elektrischen Schaltungselementen a (101) festhält; und
- Positioniermittel (202, 203, 205, 205'), um das genannte Halterungsbauteil (201) sowie das genannte Basisbauteil (104) mit dem erwähnten elektrisch verbindenden Bauteil (125) in die richtige Lage zu bringen, indem am einen aus dem genannten Halterungsbauteil sowie dem genannten Basisbauteil vorhandene Positioniervorsprünge (205; 205') in im anderen Bauteil vorgesehene Löcher (202) eingesetzt werden;
dadurch gekennzeichnet, daß
- die genannten Positioniervorsprünge eine Mehrzahl von Löchern (203) in dem erwähnten elektrisch verbindenden Bauteil durchsetzen; und
- die erwähnten ersten elektrischen Schaltungselemente a (101), das erwähnte elektrisch verbindende Bauteil (125) sowie das genannte zweite elektrische Schaltungselement b (105) durch Metallisieren und/oder Legieren verbunden sind, wobei die erwähnten ersten Endstücke und die erwähnten zweiten Endabschnitte der besagten elektrisch leitfähigen Elemente (107) aus Materialien mit unterschiedlichen Schmelzpunkten gefertigt sind.

## Revendications

1. Appareil à circuit électrique comprenant :
- un élément de connexion électrique (125) comprenant un corps de maintien (111) réalisé dans un matériau électriquement isolant et une pluralité d'éléments électriquement conducteurs (107) encastrés dans ledit corps de maintien, dans lequel des premières parties d'extrémité desdits éléments électriquement conducteurs s'étendent à travers un côté dudit corps de maintien, tandis que des secondes parties d'extrémité desdits éléments électriquement conducteurs s'étendent à travers l'autre côté dudit corps de maintien ;
- une pluralité de premiers composants de circuit électrique a (101) auxquels lesdites premières parties d'extrémité desdits éléments électriquement conducteurs sont reliées ;
- un second composant de circuit électrique b (105) auquel lesdites secondes parties d'extrémité desdits éléments électriquement conducteurs sont reliées ; et
- un élément de base (104) pour supporter ledit composant de circuit électrique b (105) ;
- un élément de maintien (201) qui maintient ladite pluralité de premiers composants de circuit électrique a (101) ; et
- des moyens de positionnement (202,203,205,205') pour positionner ledit élément de maintien (201) et ledit élément de base (104) avec ledit élément de connexion électrique (125) en insérant des saillies de positionnement (205; 205'), prévues sur l'un dudit élément de maintien ou dudit élément de base dans des trous (202) prévus sur l'autre élément ;
caractérisé en ce que
- lesdites saillies de positionnement pénètrent à travers une pluralité de trous (203) dans ledit élément de connexion électrique ; et
lesdits premiers composants de circuit électrique a (101), ledit élément de connexion électrique (125) et ledit second composant de circuit électrique b (105) sont reliés par métallisation et/ou alliage, où lesdites premières parties d'extrémité et lesdites secondes parties d'extrémité desdits éléments électriquement conducteurs (107) sont réalisées dans des matériaux ayant des points de fusion différents.
